# EUROPEAN PATENT SPECIFICATION

(11) **EP 1 235 282 B1**
(45) Date of publication and mention of the grant of the patent: **17.05.2017**
(21) Application number: 02004107.5
(22) Date of filing: 25.02.2002
(51) Int. Cl.: C30B 25/02, C30B 29/40, H01L 21/205, H01L 33/00

(54) **Method of fabricating a III-nitride film and corresponding III-nitride film**
Herstellungsverfahren einer III-nitrid-Schicht und zugehörige III-nitrid-Schicht
Procédé de fabrication d'une couche de nitrure de groupe III et couche de nitrure de groupe III correspondante

(30) Priority: 27.02.2001 JP 2001053188; 05.07.2001 US 303023 P
(43) Date of publication of application: 28.08.2002
(73) Proprietor: NGK Insulators, Ltd., Nagoya City, Aichi Pref. (JP)
(72) Inventor: Shibata, Tomohiko, Nagoya City, Aichi Pref. (JP); Tanaka, Mitsuhiro, Nagoya City, Aichi Pref. (JP); Asai, Keiichiro, Nagoya City, Aichi Pref. (JP); Oda, Osamu, Nagoya City, Aichi Pref. (JP)
(74) Representative: TBK

(56) References cited:
- EP-A- 1 065 705
- EP-A- 1 160 882
- PATENT ABSTRACTS OF JAPAN vol. 1997, no. 07, 31 July 1997 (1997-07-31) & JP 09 083016 A (NICHIA CHEM IND LTD), 28 March 1997 (1997-03-28)
- PATENT ABSTRACTS OF JAPAN vol. 1996, no. 01, 31 January 1996 (1996-01-31) & JP 07 235692 A (SONY CORP), 5 September 1995 (1995-09-05)
- PATENT ABSTRACTS OF JAPAN vol. 2000, no. 11, 3 January 2001 (2001-01-03) & JP 2000 228535 A (NIPPON TELEGR & TELEPH CORP <NTT>), 15 August 2000 (2000-08-15)

## Description

### Background of the invention

### (1) Field of the invention

This invention relates to a method for fabricating a nitride film, particularly a III nitride film usable as an underfilm of a semiconductor element such as a light-emitting diode or a high velocity IC chip.

### (2) Related Art Statement

III nitride films are employed as semiconductor films for photonic devices constituting a light-emitting diode, etc., and recently, win a lot of attention as semiconductor films for electronic devices, for example, constituting high velocity IC chips to be used in cellular phones.

Such III nitride films are usually fabricated by MOCVD methods. Concretely, a substrate on which III nitride films are formed is set onto a susceptor installed in a given reactor, and then, heated to 1000°C or over with a heater provided in or out of the susceptor. Thereafter, raw material gases are introduced with a carrier gas into the reactor and supplied onto the substrate.

On the substrate, the raw material gases are dissolved through thermochemical reaction into constituent elements, which are reacted to deposit and fabricate a desired III nitride film on the substrate.

The lattice constant of the III nitride film is affected largely by the composition of the film itself. Therefore, if the composition of the III nitride film is selected, the difference in lattice constant between the substrate and the III nitride film may become large, so that many misfit dislocations may be created at the boundary between the substrate and the III nitride film.

In this case, if another III nitride film is epitaxially grown on the III nitride film, a large amount of dislocation density of about 10¹⁰/cm² may be created in the epitaxially grown film because the misfit dislocations are propagated. As a result, the crystal quality of the epitaxially grown film may be deteriorated, and the electrical properties and the optical properties may be deteriorated.

In order to solve the above problem, such an attempt is made as fabricating a patterned mask made of SiO₂ on a substrate and epitaxially growing a given III nitride film laterally on the mask. In this case, misfit dislocations originated from the interface between the substrate and the film are propagated not vertically but laterally above the mask. As a result, the threading dislocation density above the mask is reduced.

In the fabrication of the patterned mask, however, since a photolithography process including an etching operation is required, the total fabrication process for the III nitride film may become complicated.

JP09083016 discloses a buffer multilayer on a 6H-SiC substrate comprising a first AlN layer and a second AlₓGa₁₋ₓN layer with decreasing x.

JP07235692 discloses a dual buffer layer on sapphire comprising a first AlN layer and a second AlGaN layer, formed at temperatures around 500°C.

It is an object of the present invention to provide a method able to easily fabricate a III nitride film with lower dislocation density.

In order to achieve the above object, this invention relates to a method as defined in claim 1 and an underlayer as defined in claim 5.

In particular, the invention relates to a method for fabricating a III nitride film, comprising the steps of:
forming a lower region having a composition of Alₓ₁Gaₓ₂Inₓ₃N (x1+x2+x3=1, 0.5≤x1≤1.0), at 1100°C or over by a MOCVD method, and
forming an upper region having a composition of Al_{y1}Ga_{y2}In_{y3}N (y1+y2+y3=1, 0≤y1≤x1-0.1), whereby a boundary face to divide a given III nitride film into the lower region and the upper region with the Al content difference of 10 atomic percent or over is created, wherein said lower region is created on a C-faced sapphire substrate within 1100-1250°C, and wherein the dislocation density of the upper region is one-fifth as large as the dislocation density of the lower region.

The inventors had intensely studied to obtain a III nitride film with lower dislocation density through an easy fabricating process without a patterned mask made of SiO₂. As a result, they found out that by forming the above-mentioned boundary face in the III nitride film, the dislocation density of the III nitride film can be reduced, and thus, the crystal quality of the III nitride film can be improved.

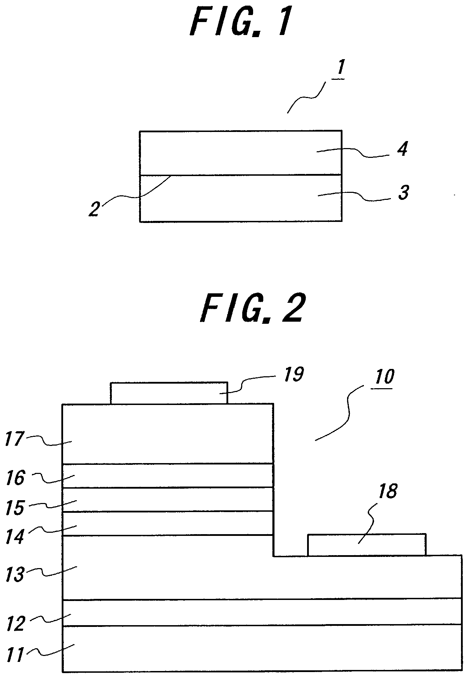

Fig. 1 is an explanatory view of a fabricating method of a III nitride film according to the present invention. In a III nitride film 1 including Al element shown in Fig. 1, a boundary face 2 is formed and thus, the III nitride film is divided into two regions 3 and 4. The Al content of the upper region 4 is lower than the Al content of the lower region 3 by 10 atomic percentages or over. Herein, the Al content of the lower region 3 is set to 50 atomic percentages or over. In this case, the Al content as mentioned above is defined as the amount included in all of the III elements in the III nitride film.

The III nitride film 1 is fabricated on a given substrate (not shown), and thus, the much dislocations may be created, originated from the dislocations contained in the substrate and the misfit dislocations between the substrate and the III nitride film 1 due to the large difference in lattice constant.

However, the dislocation propagation in the III nitride film can be inhibited by the boundary face 2. Therefore, if many dislocations are propagated in the III nitride film 1, they can not be propagated beyond the boundary face 2, and thus, remain only in the lower region 3 or at the boundary face 2. As a result, the dislocation density of the III nitride film can be reduced in the upper region 4.

As a result, the crystal quality of the upper region 4 of the III nitride film 1 can be improved. Therefore, if a given function is provided in the upper region 4 in advance, the III nitride film 1 can be employed as a given semiconductor film entirely.

Particularly, the III nitride film 1 is preferably used as an underfilm of a semiconductor element such as a semiconductor light-emitting element, e.g., a light-emitting diode or a high velocity IC chip. In this case, since another semiconductor layer is fabricated on the upper region 4 of the III nitride film 1 which has a good crystal quality, the crystal quality of the semiconductor layer can be improved. As a result, the luminous efficiency or the high velocity response of the semiconductor element can be remarkably enhanced.

### Brief Description of the Drawings

For better understanding of the present invention, reference is made to the attached drawings, wherein
Fig. 1 is an explanatory view of a fabricating method of III nitride film according to the present invention, and
Fig. 2 is a cross sectional view showing a semiconductor light-emitting element using a III nitride film as an underfilm (under layer) fabricated according to the present invention.

### Description of the Preferred Embodiments

This invention will be described in detail, with reference to figures, hereinafter. In the fabricating method of III nitride film of the present invention, a boundary face is formed in a III nitride film to be divided in two region in the thickness direction. The composition of the divided lower region is defined as Alₓ₁Gaₓ₂Inₓ₃N (x1+x2+x3=1), and the composition of the divided upper region is defined as Al_{y1}Ga_{y2}In_{y3}N (y1+y2+y3=1). Also, it is required that the relations of 0.5≤x1≤1.0 and 0≤y1≤x1-0.1 are satisfied. Moreover, it is desired that the relations of 0.7≤x1≤1.0 and 0≤y1≤x1-0.5 are satisfied. In this case, the dislocation propagation can be inhibited more effectively by the boundary face, and thus, the dislocation density of the upper region from the boundary face can be drastically reduced.

As mentioned above, the lower region has the composition of Alₓ₁Gaₓ₂Inₓ₃N (x1+x2+x3=1, 0.5≤x1≤1.0), and is made at 1100°C or over. In this case, the screw-type dislocations and the mixed dislocations in the lower region of the III nitride film disappear effectively, and thus, the dislocation density of the upper region of the III nitride film can be also improved more effectively.

In this case, the crystallinity of the lower region of the III nitride film can be also improved entirely up to 90 seconds or below in full width of half maximum (FWHM) of X-ray rocking curve at (002) reflection, and thus, the crystallinity of the upper region can be also enhanced, compared with a conventional III nitride film fabricated by using a buffer layer fabricated at lower temperature.

The upper limited value of the fabrication temperature of the lower region of the III nitride film is set 1250°C. If the upper limited value is set at a temperature beyond 1250°C, the dislocation can not vanish more, and particularly, the crystal quality of the upper region of the III nitride film may be deteriorated due to the surface roughness.

The III nitride film is made at 1100°C or over, by a MOCVD method using an Al raw material gas, a nitrogen raw material gas and another raw material gas such as a Ga raw material gas. In forming the lower region, the amount of supplied Al raw material gas is set larger, and in forming the upper region, the amount of the supplied Al raw material gas is set smaller, so that the Al content in the upper region is set smaller than the Al content in the lower region by 10 atomic percent or over.

According to the above-mentioned fabricating method, the boundary face, which divides the III nitride film into the lower region and the upper region stepwisely by the difference in Al content of 10 atomic percentage or over, is formed inevitably.

As mentioned above, the dislocation propagation can be inhibited by the boundary face, and thus, the dislocation density in the upper region is reduced one-fifth as much as that in the lower region, and concretely can be reduced up to 10⁸-10¹⁰/cm².

As a result, the crystallinity of the upper region of the III nitride film can be improved up to 300 seconds or below in FWHM of X-ray rocking curve at (002) reflection, which is remarkably enhanced in comparison with a conventional III nitride film fabricated by using a buffer layer formed at lower temperature.

Fig. 2 is a cross sectional view showing a semiconductor light-emitting element using a III nitride film as an underfilm (under layer) fabricated according to the fabricating method as mentioned above.

A semiconductor light-emitting element 10 depicted in Fig. 2 includes a substrate 11, an under layer 12 fabricated according to the fabricating method of the present invention, and a first conductive layer 13 made of, e.g., n-AlGaN.

Moreover, the semiconductor light-emitting element 10 includes, on the first conductive layer 13, a first cladding layer 14 made of, e.g., n-AlGaN, a light-emitting layer 15 made of, e.g., i-AlGaN and formed on the first cladding layer 14, a second cladding layer 16 made of, e.g., p-AlGaN and formed on the light-emitting layer 15, and a second conductive layer 17 made of, e.g., p-AlGaN and formed on the second cladding layer 16.

The first conductive layer 13 is partially exposed and an n-type electrode 18 made of, e.g., Al/Ti is provided on the exposed surface of the layer 13. Then, a p-type electrode 19 made of, e.g., Au/Ni, is provided on the second conductive layer 17.

As mentioned above, since the under layer 12 is made according to the fabricating method of the present invention, the crystal quality of the surface layer of the under layer 12 is improved. Therefore, since the crystal qualities of the conductive layers, the cladding layers and the light-emitting layer are also improved, the luminous efficiency of the semiconductor light-emitting element can be enhanced.

Each layer such as the conductive layer or the cladding layer of the semiconductor light-emitting element may be made by a MOCVD method well known.

### Examples:

This invention will be concretely described, hereinafter.

### (Example)

A C-faced sapphire single crystal substrate was employed, and then, set and attracted on a susceptor installed in a quartz reactor of a MOCVD apparatus, and heated to 1200°C with a heater built in the susceptor.

Then, a trimethylaluminum (TMA) as an Al raw material gas and an ammonia (NH₃) gas as a nitrogen raw material gas were introduced and supplied with a hydrogen carrier gas onto the substrate at the flow rate of TMA/NH₃= 0.5 sccm/350 sccm, to form an AlN film (lower region) in a thickness of 1 µm through the epitaxial growth for 60 minutes.

The dislocation density of the AlN film was turned out to be 10¹⁰/cm² by TEM observation, and the FWHM of the AlN film was turned out to be about 50 seconds at (002) reflection by X-ray diffraction.

Then, the temperature of the substrate was varied to 1050°C from 1200°C, and a trimethylgallium (TMG) as a Ga raw material gas was introduced with the TMA gas and the NH₃ gas at the flow rate of TMA/TMG/NH₃= 0.1 sccm/0.9 sccm/3000 sccm, to form an Al_{0.1}Ga_{0.9}N film (upper region) in a thickness of 2 µm through the epitaxial growth for 60 minutes, and thus, to form a III nitride film constructed of the AlN film and the Al_{0.1}Ga_{0.9}N film.

The dislocation density of the Al_{0.1}Ga_{0.9}N film was turned out to be 10⁹/cm² by TEM observation, and the FWHM of the Al_{0.1}Ga_{0.9}N film was turned out to be about 150 seconds at (002) reflection by X-ray diffraction.

### (Comparative Example)

A C-faced sapphire single crystal substrate was set on the susceptor and heated at 600°C by the heater built in the susceptor. Then, the TMA, the TMG and the NH₃ gas were introduced and supplied onto the substrate, to form a buffer layer in a thickness of about 200Å. Then, the temperature of the substrate was varied to 1050°C from 600°C, the same Al_{0.1}Ga_{0.9}N film was formed in a thickness of 2 µm, to a III nitride film constructed of the buffer layer and the Al_{0.1}Ga_{0.9}N film.

The dislocation density of the Al_{0.1}Ga_{0.9}N film was turned out to be 2×10¹⁰/cm² by TEM observation, and the FWHM of the Al_{0.1}Ga_{0.9}N film was turned out to be about 350 seconds at (002) reflection by X-ray diffraction.

As is apparent from Example and Comparative Example, the dislocation density in the Al_{0.1}Ga_{0.9}N film of the upper region of the resulting III nitride film in Example is lowered one-fifth or below as much as that in Comparative Example, and the crystallinity of the Al_{0.1}Ga_{0.9}N film of the upper region in Example is more enhanced than that in Comparative Example.

Therefore, if the III nitride film in Example, which is fabricated according to the present invention, is employed as an underfilm of a semiconductor light-emitting element, the crystal qualities of various semiconductor layer to be formed on the III nitride film can be improved and thus, the performance such as luminous efficiency of the semiconductor light-emitting element can be enhanced. Similarly, if the III nitride film in Example is employed as an underfilm of a high velocity IC chip, the crystal qualities of various semiconductor layer to be formed on the III nitride film can be improved and thus, the performance such as response property of the IC chip can be enhanced.

Although the present invention was described in detail with reference to the above examples, this invention is not limited to the above disclosure and every kind of variation and modification may be made without departing from the scope of the present invention.

As is explained above, a III nitride film of low dislocation density and thus, good crystal quality can be easily fabricated, according to the present invention. Therefore, if the III nitride film is employed as an underfilm of a given semiconductor element, the crystal quality of the element can be totally improved, and thus, the performance of the element can be enhanced.

A lower region having a composition of Alₓ₁Gaₓ₂Inₓ₃N (x1+x2+x3=1, 0.5≤x1≤1.0) is formed through epitaxial growth by a MO CVD method at 1100°C or higher, and subsequently, an upper region having a composition of Al_{y1}Ga_{y2}In_{y3}N (y1+y2+y3=1, 0≤y1≤x1-0.1) is formed through epitaxial growth by a CVD method, wherein the dislocation density of the upper region is one-fifth as large as the dislocation density of the lower region. Thereby, a boundary face to divide a given III nitride film into the lower region and the upper region has the Al content difference of 10 atomic percent or over thereat.

## Claims

1. A method for fabricating a III nitride film, comprising the steps of:
forming a lower region (3) having a composition of Alₓ₁Gaₓ₂Inₓ₃N (x1 + x2 + x3 = 1, 0.5 ≤ x1 ≤ 1.0), at 1100°C or over by a MOCVD method, and
forming an upper region (4) having a composition of Al_{y1}Ga_{y2}In_{y3}N (y1 + y2 + y3 = 1, 0 ≤ y1 ≤ x1-0.1), whereby a boundary face, which divides a given III nitride film into the lower region (3) and the upper region (4) with the Al content difference of 10 atomic percent or over, is created,
**characterized in that**
said lower region (3) is created on a C-faced sapphire substrate within 1100-1250°C, and
the dislocation density of said upper region (4) is one-fifth as large as the dislocation density of said lower region (3).

2. A fabricating method as defined in claim 1, wherein the full width at half maximum in X-ray rocking curve of said lower region (3) is 90 seconds or below.

3. A fabricating method as defined in any one of claims 1-2 , wherein the Al content of said III nitride film is varied stepwisely in the thickness direction.

4. A fabricating method as defined in any one of claims 1-3, wherein the full width at half maximum in X-ray rocking curve of said upper region (4) is 300 seconds or below.

5. An underfilm for a semiconductor element including a III nitride film comprises:
a lower region (3) having a composition of Alₓ₁Gaₓ₂Inₓ₃N (x1 + x2 + x3 = 1, 0.5 ≤ x1 ≤ 1.0) and being formed on a C-faced sapphire substrate,
an upper region (4) having a composition of Al_{y1}Ga_{y2}In_{y3}N (y1 + y2 + y3 = 1, 0 ≤ y1 ≤ x1-0.1), and
a boundary face, which divides a given III nitride film into the lower region (3) and the upper region (4) with the Al content difference of 10 atomic percentages or over,
**characterized in that** the dislocation density of said upper region (4) is one-fifth as large as the dislocation density of said lower region (3).

6. A semiconductor element including an underfilm for a semiconductor element as defined in claim 5.

## Patentansprüche

1. Herstellungsverfahren für eine III-Nitridschicht, mit den Schritten:
Ausbilden eines unteren Bereichs (3) mit einer Zusammensetzung aus Alₓ₁Gaₓ₂Inₓ₃N (x1 + x2 + x3 = 1, 0,5 ≤ x1 ≤ 1,0) bei 1100°C oder höher durch ein MOCVD-Verfahren, und
Ausbilden eines oberen Bereichs (4) mit einer Zusammensetzung aus Al_{y1}Ga_{y2}In_{y3}N (y1 + y2 + y3 = 1, 0 ≤ y1 ≤ x1-0,1), wodurch eine Grenzfläche erzeugt wird, die eine gegebene III-Nitridschicht in den unteren Bereich (3) und den oberen Bereich (4) mit dem Unterschied im Al-Gehalt von 10 Atomprozent oder mehr unterteilt,
**dadurch gekennzeichnet, dass**
der untere Bereich (3) auf einem c-flächigen Sapphirsubstrat bei 1100-1250°C erzeugt wird, und
die Versetzungsdichte des oberen Bereiches (4) ein Fünftel der Versetzungsdichte des unteren Bereiches (3) beträgt.

2. Herstellungsverfahren nach Anspruch 1, wobei die Halbwertsbreite einer Röntgen-Rocking-Kurve der unteren Region (3) 90 Sekunden oder weniger beträgt.

3. Herstellungsverfahren nach einem der Ansprüche 1-2, wobei der Al-Gehalt der III-Nitridschicht stufenweise in Dickenrichtung variiert wird.

4. Herstellungsverfahren nach einem der Ansprüche 1-3, wobei die Halbwertsbreite einer Röntgen-Rocking-Kurve des oberen Bereichs (4) 300 Sekunden oder weniger beträgt.

5. Unterschicht für ein Halbleiterelement mit einem III-Nitrid, mit:
einem unteren Bereich (3) mit einer Zusammensetzung aus Alₓ₁Gaₓ₂Inₓ₃N (x1 + x2 + x3 = 1, 0,5 ≤ x1 ≤ 1,0), der auf einem c-flächigen Sapphirsubstrat ausgebildet ist,
einem oberen Bereich (4) mit einer Zusammensetzung aus Al_{y1}Ga_{y2}In_{y3}N (y1 + y2 + y3 = 1, 0 ≤ y1 ≤ x1-0,1), und
einer Grenzfläche, die eine gegebene Nitridschicht in den unteren Bereich (3) und den oberen Bereich (4) mit dem Unterschied im Al-Gehalt von 10 Atomprozent oder mehr unterteilt,
**dadurch gekennzeichnet, dass**
die Versetzungsdichte des oberen Bereiches (4) ein Fünftel der Versetzungsdichte des unteren Bereiches (3) beträgt.

6. Halbleiterelement mit einer Unterschicht für ein Halbleiterelement nach Anspruch 5.

## Revendications

1. Procédé de fabrication d'un film en nitrure III, comprenant les étapes suivantes :
formation d'une région inférieure (3) de composition Alₓ₁Gaₓ₂Inₓ₃N (x1 + x2 + x3 = 1, 0,5 ≤ x1 ≤ 1,0), à 1 100 °C ou plus par un procédé MOCVD, et
formation d'une région supérieure (4) de composition Al_{y1}Ga_{y2}In_{y3}N (y1 + y2 + y3 = 1, 0 ≤ y1 ≤ x1-0,1),
par lequel une interface, qui divise un film en nitrure III donné en une région inférieure (3) et une région supérieure (4) ayant une différence de teneur Al de 10 % atomique ou plus, est créée,
**caractérisé en ce que**
ladite région inférieure (3) est créée sur un substrat de saphir à face C dans la plage de 1 100 à 1 250 °C, et
la densité des dislocations de ladite région supérieure (4) est un cinquième aussi importante que la densité des dislocations de ladite région inférieure (3).

2. Procédé de fabrication selon la revendication 1, dans lequel la largeur à mi-hauteur sur la courbe de basculement de rayons X de ladite région inférieure (3) est de 90 secondes ou moins.

3. Procédé de fabrication selon l'une quelconque des revendications 1 à 2, dans lequel la teneur en Al dudit film en nitrure III varie par incréments dans le sens de l'épaisseur.

4. Procédé de fabrication selon l'une quelconque des revendications 1 à 3, dans lequel la largeur à mi-hauteur sur la courbe de basculement de rayons X de ladite région supérieure (4) est de 300 secondes ou moins.

5. Sous-film pour élément semi-conducteur contenant un film en nitrure III qui comprend :
une région inférieure (3) de composition Alₓ₁Gaₓ₂Inₓ₃N (x1 + x2 + x3 = 1, 0,5 ≤ x1 ≤ 1,0) formée sur un substrat de saphir à face C,
une région supérieure (4) de composition Al_{y1}Ga_{y2}In_{y3}N (y1 + y2 + y3 = 1, 0 ≤ y1 ≤ x1-0,1), et
une interface, qui divise un film en nitrure III donné en une région inférieure (3) et une région supérieure (4) ayant une différence de teneur Al de 10 % atomique ou plus,
**caractérisé en ce que**
la densité des dislocations de ladite région supérieure (4) est un cinquième aussi importante que la densité des dislocations de ladite région inférieure (3).

6. Elément semi-conducteur contenant un sous-film pour élément semi-conducteur selon la revendication 5.
